# EUROPÄISCHE PATENTSCHRIFT

(11) **EP 3 123 185 B1**
(45) Veröffentlichungstag und Bekanntmachung des Hinweises auf die Patenterteilung: **12.08.2020**
(21) Anmeldenummer: 15707574.8
(22) Anmeldetag: 20.02.2015
(51) Int. Cl.: G01R 31/367, G01R 31/3842, G01R 31/389

(54) **ELEKTRONISCHER BATTERIESENSOR UND VERFAHREN ZUR BESTIMMUNG EINES INNENWIDERSTANDES EINER BATTERIE**
ELECTRONIC BATTERY SENSOR AND METHOD FOR DETERMINING AN INTERNAL RESISTANCE OF A BATTERY
CAPTEUR DE BATTERIE ÉLECTRONIQUE ET PROCÉDÉ DE DÉTERMINATION DE LA RÉSISTANCE INTERNE D'UNE BATTERIE

(30) Priorität: 25.03.2014 DE 102014205495
(43) Veröffentlichungstag der Anmeldung: 01.02.2017
(73) Patentinhaber: Robert Bosch GmbH, 70442 Stuttgart (DE)
(72) Erfinder: KIZLER, Joachim, 70499 Stuttgart (DE); MOTZ, Juergen, 71711 Steinheim An Der Murr (DE); SCHOCH, Eberhard, 70469 Stuttgart-Feuerbach (DE); KOENIGSMANN, Martin, Holger, 70197 Stuttgart (DE)
(86) Internationale Anmeldenummer: PCT/EP2015/053567
(87) Internationale Veröffentlichungsnummer: WO 2015/144367

(56) Entgegenhaltungen:
- DE-A1-102009 001 300
- DE-A1-102010 043 388
- JP-A- 2013 044 580
- US-A1- 2005 194 976
- US-A1- 2012 274 285

## Beschreibung

### Stand der Technik

Die Erfindung geht aus von einem elektronischen Batteriesensor und einem Verfahren zur Bestimmung eines Innenwiderstandes einer Batterie nach der Gattung der unabhängigen Ansprüche. Aus der WO 2006/037694 ist ein Verfahren zur Rekonstruktion eines elektrischen Signals bekannt. In diesem Verfahren wird ein analoges Messsignal mittels eines Analog-Digitalwandlers mit hoher Abtastrate abgetastet. Als Messsignale dienen hier bspw. Spannung und Stromstärke einer Batterie, aus denen dann anschließend ein Innenwiderstand berechnet werden kann. Der Innenwiderstand wird hierbei berechnet, indem eine Spannungsdifferenz durch eine Stromstärkendifferenz geteilt wird. Üblicherweise wird zudem vor der Abtastung das Messsignal tiefpassgefiltert, um das Abtasttheorem einzuhalten. Hierdurch kann das Auftreten von Aliasing vermieden werden. Die zur Berechnung des Innenwiderstandes nötigen Strom- und Spannungssignale werden in dem aufgezeigten Verfahren durch einen Strom- bzw. Spannungssensor erfasst.

DE 10 2010 043388 offenbart ein Verfahren gemäss dem einleitenden Teil des Anspruchs 1, bei welchem der Innenwiderstand einer Batteriezelle einer Batterie bestimmt wird.

Die Aufgabe der Erfindung besteht darin, eine hohe Abtastrate zu ermöglichen und zeitgleich einen hohen Rechenaufwand für die Berechnung des Innenwiderstandes zu vermeiden.

### Vorteile der Erfindung

Die Erfindung geht aus von einem elektronischen Batteriesensor umfassend wenigstens ein erstes Erfassungsmittel zur Erfassung von Messwerten und ein Batteriemodell zur Ermittlung des Innenwiderstands einer Batterie, wobei jeder Messwert zeitgleiche Informationen von wenigstens zwei korrespondierenden Messgrößen umfasst, insbesondere Batteriestrom und Batteriespannung, und wobei zwei aufeinanderfolgende Messwerte je ein Messpaar darstellen. Der Kern der Erfindung besteht darin, dass der Batteriesensor zumindest ein Auswahlmittel umfasst, welches dazu eingerichtet ist, aus einer bestimmten Anzahl von Messpaaren wenigstens ein Messpaar als Selektionspaar auszuwählen und dem Batteriemodell zur Ermittlung des Innenwiderstandes zur Verfügung zu stellen, wobei die Anzahl der Messpaare größer als die Anzahl der Selektionspaare ist. Vorteilhaft ist hierbei, dass dadurch weiterhin mit einer hohen Abtastrate abgetastet werden kann, jedoch nur ein Teil dieser abgetasteten Messwerte an das Batteriemodell weitergegeben werden. Hierdurch wird der Rechenaufwand des Batteriemodells gering gehalten und trotzdem wird durch die hohe Abtastrate eine hohe Genauigkeit der Messung gewährleistet. Es ist hierdurch also möglich mit einer hohen Frequenz abzutasten und nur einen Teil dieser abgetasteten Messpaare an das Batteriemodell weiterzugeben, wodurch die Widerstandsberechnung im Batteriemodell bei einer geringeren Frequenz ablaufen kann. Zudem können durch die hohe Abtastfrequenz kleine Strom- und Spannungsschwankungen an der Batterie erkannt werden, welche bei einer geringeren Abtastfrequenz nicht erkannt worden wären. Dies hat den Vorteil, dass nicht nur Erregungen an der Batterie auf Grund des Motorstarts erkannt werden, welcher eine große Strom- bzw. Spannungsschwankung hervorruft, sondern auch kleinere Erregungen. So ist dies insbesondere bei Hybrid- und Elektrofahrzeugen von Vorteil, die keinen klassischen Motorstart aufweisen.

Eine vorteilhafte Ausgestaltung der Erfindung sieht vor, dass das Verhältnis von einer Arbeitsfrequenz der Erfassungsmittels und/oder des Auswahlmittels zu einer Verarbeitungsfrequenz des Batteriemodells dem Verhältnis von der Anzahl der Messpaare zur Anzahl der Selektionspaare entspricht. Vorteilhaft ist hierbei, dass durch die Wahl von einer bestimmten Anzahl an Messpaare aus der dann eine bestimmte Anzahl an Selektionspaare gewählt wird, das Verhältnis von Arbeitsfrequenz zu Verarbeitungsfrequenz eingestellt werden kann.

Gemäß einer weiteren vorteilhaften Ausgestaltung der Erfindung ist vorgesehen, dass das Auswahlmittel dazu eingerichtet ist, dass jedes n-te Messpaar der gewählten Anzahl von Messpaaren als Selektionspaar ausgewählt wird. Vorteilhaft ist hierbei, dass dies einen sehr einfachen Algorithmus zur Auswahl des Selektionspaares darstellt. Hierdurch kann also der Rechenaufwand im Auswahlmittel sehr gering gehalten werden.

Gemäß einer weiteren vorteilhaften Ausgestaltung der Erfindung ist vorgesehen, dass das Auswahlmittel dazu eingerichtet ist, in Abhängigkeit der Gradienten der Messpaare wenigstens ein Messpaar als Selektionspaar auszuwählen, insbesondere das Messpaar mit dem betragsmäßig größten Stromgradienten. Vorteilhaft ist hierbei, dass hierdurch sehr gut geeignete Messpaare ausgewählt werden, um ein sehr gutes Ergebnis bei der anschließenden Berechnung des Innenwiderstandes durch das Batteriemodell zu erhalten.

In einer weiteren vorteilhaften Ausgestaltung der Erfindung ist vorgesehen, dass das Auswahlmittel dazu eingerichtet ist, einen Mittelwert aller Messpaare der bestimmten Anzahl der Messpaare zu bilden und diesen Mittelwert als Selektionspaar auszuwählen. Vorteilhaft ist hierbei, dass einzelne Messfehler durch die Bildung des Mittelwerts der Messpaare ausgeglichen werden können.

Gemäß einer weiteren vorteilhaften Ausgestaltung der Erfindung ist vorgesehen, dass der Batteriesensor einen Bandpassfilter umfasst, wobei der Bandpassfilter als Eingangsgrößen die Messwerte aufweist und dazu eingerichtet ist, die Ausgangsgrößen dem Auswahlmittel zur Verfügung zu stellen. Vorteilhaft ist hierbei, dass auch niederfrequente Störsignale gefiltert werden, welche nicht zur Berechnung des Innenwiderstandes herangezogen werden sollen.

Eine weitere vorteilhafte Ausgestaltung der Erfindung sieht vor, dass der Batteriesensor ein Anpassmittel umfasst, welches dazu eingerichtet ist, die Phasen der korrespondierenden Messgrößen aufeinander anzupassen. Vorteilhaft ist hierbei, dass fehlerhafte Messwerte aufgrund von Phasenverschiebungen vermieden werden können. Hierdurch kann die Qualität des Ergebnisses der anschließenden durchgeführten Berechnung des Innenwiderstandes verbessert werden.

### Zeichnungen

Figur 1 zeigt ein erstes Ausführungsbeispiel eines erfindungsgemäßen Batteriesensors, der an einer Batterie angeschlossen ist.
Figur 2 zeigt ein Flussdiagramm des erfindungsgemäßen Verfahrens zur Bestimmung eines Innenwiderstandes, insbesondere mittels eines Batteriesensors nach Figur 1.
Figur 3 zeigt ein Diagramm, in dem der erfasste Batteriestrom gegenüber der Zeit aufgetragen ist.

### Ausführungsbeispiele

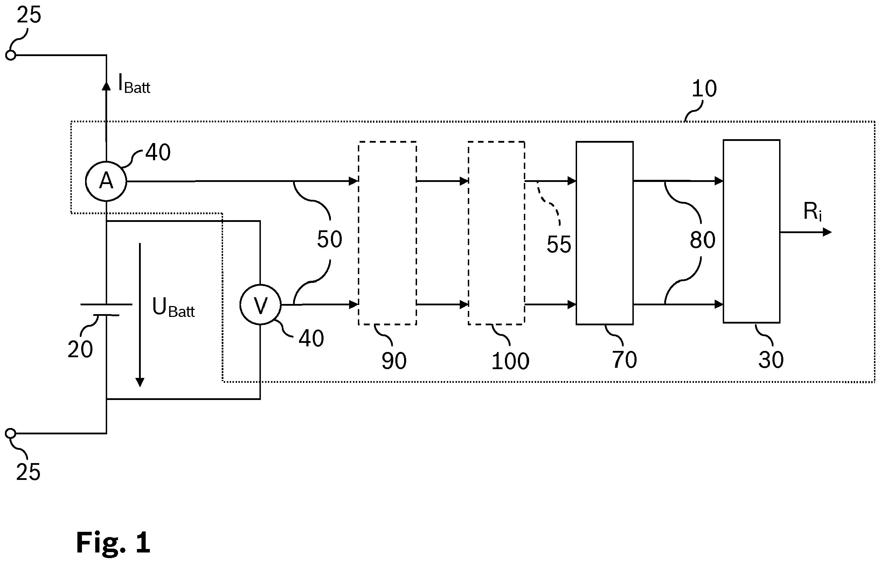

Figur 1 zeigt ein erstes Ausführungsbeispiel eines erfindungsgemäßen Batteriesensors. Dargestellt ist eine Batterie 20. An den Klemmen 25 sind eine Batteriespannung U_{Batt} und ein Batteriestrom I_{Batt} abgreifbar. Des Weiteren ist ein Batteriesensor 10 dargestellt. Dieser Batteriesensor 10 umfasst zwei Erfassungsmittel 40, welche die Batteriespannung U_{Batt} und den Batteriestrom I_{Batt} erfassen. Die Erfassungsmittel 40 sind mit einem Auswahlmittel 70 verbunden, wodurch Messwerte 50 bzw. Messpaare 60 vom Erfassungsmittel 40 an das Auswahlmittel 70 übertragbar sind. Optional ist zwischen den Erfassungsmitteln 40 und dem Auswahlmittel 70 ein Bandpassfilter 90 angeordnet. Ebenso optional ist zwischen den Erfassungsmitteln 40 und dem Auswahlmittel 70 ein Anpassmittel 100 angeordnet. Des Weiteren ist das Auswahlmittel 70 mit einem Batteriemodell 30 verbunden. Hierdurch können die Selektionspaare 80 dem Batteriemodell 30 zur Verfügung gestellt werden. Anhand der Selektionspaare 80 kann das Batteriemodell 30 den Innenwiderstand Rᵢ berechnen und zur Weiterverabeitung ausgeben.

Die in Figur 1 aufgezeigte Batterie 20 kann beispielsweise eine Autobatterie sein, aber auch jeglicher andere Energiespeicher. Des Weiteren kann das Batteriemodell 30 bspw. als erweiterter Kalman-Filter ausgestaltet sein.

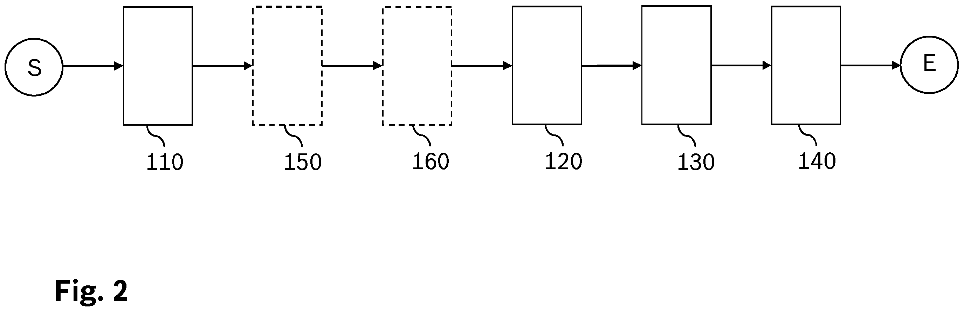

Figur 2 zeigt ein Flussdiagramm eines erfindungsgemäßen Betriebsverfahrens zur Bestimmung des Innenwiderstandes einer Batterie, insbesondere mittels eines Batteriesensors nach Figur 1. Das Verfahren beginnt im Start S. Anschließend werden in einem ersten Schritt 110 die Messwerte 50 erfasst. Hierbei weist jeder Messwert 50 zeitgleiche Informationen von wenigstens zwei korrespondierenden Messgrößen auf, nämlich Batteriestrom I_{Batt} und Batteriespannung U_{Batt}. Zwei aufeinanderfolgende Messwerte 50 stellen dabei jeweils ein Messpaar 60 dar. In einem optionalen Schritt 150 werden anschließend die erfassten Messwerte 50 bzw. die Messpaare 60 bandpassgefiltert. Der Bandpassfilter 90 stellt dabei eine Kombination aus einem Hochpass- und einem Tiefpassfilter dar. Der Tiefpassfilter dient hierbei dazu, hochfrequente Anteile zu filtern, um das Abtasttheorem einzuhalten. Der Hochpassfilter dient dagegen dazu, niederfrequente Störsignale zu filtern, wie bspw. das Pulsweitenmodulationssignal zur Ansteuerung von LEDs. In einem weiteren optionalen Schritt 160 werden die Phasen der korrespondierenden Messgrößen aufeinander angepasst. Anschließend wird in einem Schritt 120 wenigstens ein Messpaar 60 als Selektionspaar 80 aus einer bestimmten Anzahl von Messpaaren 60 ausgewählt. Für die Auswahl des Selektionspaares 80 stehen hierbei mehrere Alternativen zur Verfügung. So kann in einer ersten Alternative jedes n-te Messpaar 60 aus einer Anzahl von Messpaaren 60 als Selektionspaar 80 gewählt werden. In einer weiteren Alternative wird das Messpaar 60 als Selektionspaar 80 gewählt, welches den größten Stromgradienten aufweist. In noch einer weiteren Alternative wird der Mittelwert der bestimmten Messpaare 60 gebildet und dieser Mittelwert als Selektionspaar 80 ausgewählt. In einem anschließenden Schritt 130 wird dann das Selektionspaar 80 dem Batteriemodell 30 zur Berechnung des Innenwiderstandes Rᵢ zur Verfügung gestellt. Anhand des zur Verfügung gestellten Selektionspaares 80 wird daraufhin in einem Schritt 140 der Innenwiderstand Rᵢ durch das Batteriemodell 30 berechnet. Schließlich endet das Verfahren im Ende E.

Im Normalfall laufen mehrere dieser Verfahren nach Figur 2 zeitversetzt ab. So wird bspw. eine Anzahl von bestimmten Messpaaren 60 erfasst und diese wie aufgezeigt weiterverarbeitet, wobei während der Verarbeitung dieser Messpaare 60 bereits neue Messpaare erfasst und ebenfalls weiterverarbeitet werden. Des Weiteren kann durch das Verhältnis der bestimmten Anzahl von Messpaaren 60 zu einer daraus ausgewählten Anzahl von Selektionspaaren 80 ein Komprimierungsfaktor vorgegeben werden. Hierdurch kann also die erfasste Menge an Messpaaren 60 durch eine gezielte Auswahl von Messpaaren 60 als Selektionspaare 80 reduziert werden. Dadurch kann das Erfassen 110 der Messwerte 50 bzw. Messpaare 60, das Auswählen 120 der Selektionspaare 80 sowie ggf. das Bandpassfiltern 140 und das Phasenanpassen 150 bei einer hohen Arbeitsfrequenz fₓ ablaufen. Dagegen kann die Bestimmung des Innenwiderstandes Rᵢ durch das Batteriemodell 30 aufgrund von einer durch das Auswählen 120 reduzierten Datenmenge bei einer geringeren Verarbeitungsfrequenz f_{y} ablaufen.

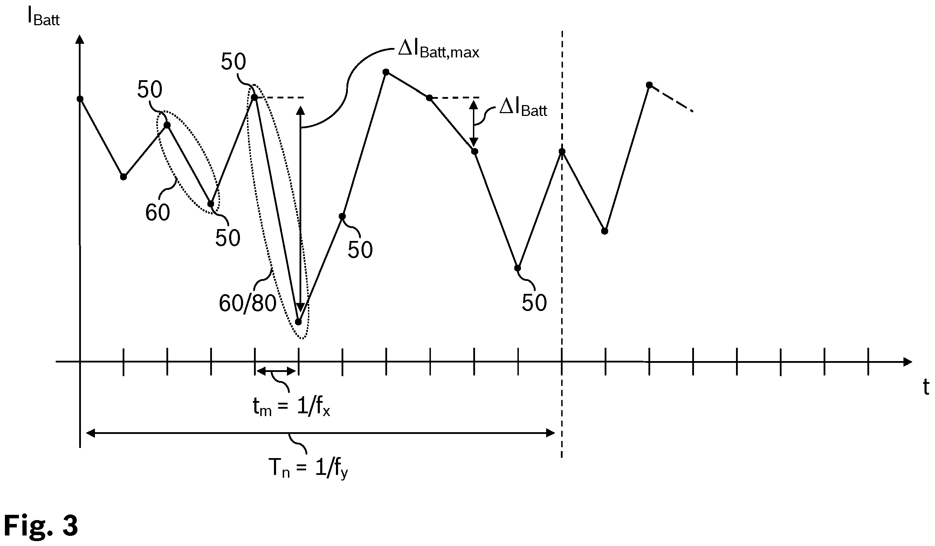

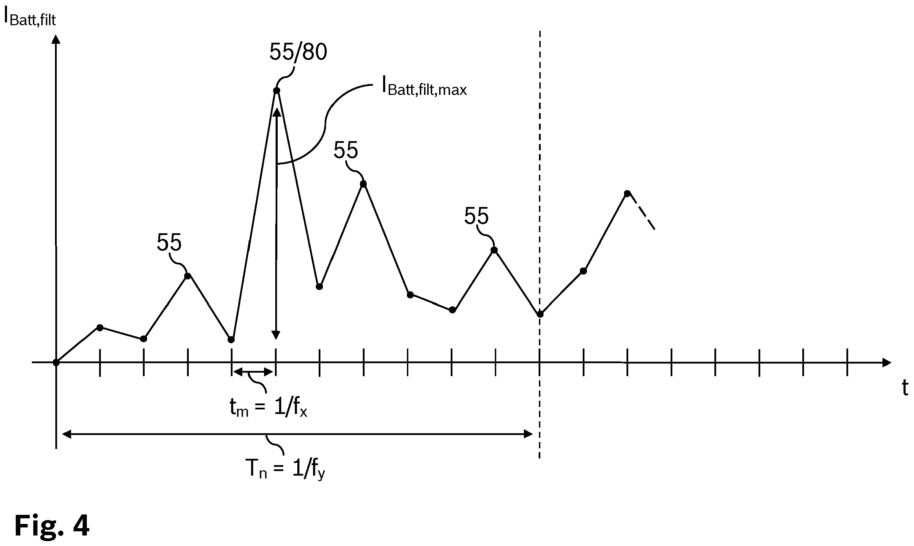

Figur 3 zeigt ein Diagramm, in dem der erfasste Batteriestrom gegenüber der Zeit aufgetragen ist. Dargestellt sind hierbei die erfassten Messwerte 50, die in jeweils nach einer Zeitspannen tₘ mit einem kontinuierlichen Abstand erfasst werden. Der Kehrwert der Zeitspanne tₘ stellt hierbei die Arbeitsfrequenz fₓ des Erfassungsmittels 40 und/oder des Auswahlmittels 70 dar. Ebenso weisen der optionale Bandpassfilter 90 und das optinale Anpassmittel 100 diese Arbeitsfrquenz fₓ auf. Ein Messwert 50 besteht jeweils aus dem Wert des Batteriestroms I_{Batt} sowie der dazugehörige Wert der Batteriespannung U_{Batt} zum selben Zeitpunkt, wobei die Batteriespannung U_{Batt} nicht bildlich dargestellt ist. Zwei aufeinanderfolgende Messwerte 50 stellen hierbei jeweils ein Messpaar 60 dar. Des Weiteren wird die Differenz zwischen zwei Messwerten 50 eines Messpaares 60 als Gradient bezeichnet. So besitzt jedes Messpaar 60 also einen Stromgradienten ΔI_{Batt} und einen Spannungsgradienten AU_{Batt}. Hierbei wird der Stromgradient AI_{Batt} aus einer bestehenden Anzahl von Messpaaren 60, welcher betragsmäßg am Größten ist, als maximaler Stromgradient ΔI_{Batt, max} bezeichnet. Gleiches gilt für den Spannungsgradienten ΔU_{Batt}. Für die Auswahlbedingung nach dem größten Stromgradienten ΔI_{Batt, max} ist in Figur 3 das Selektionspaar 80 als ausgewähltes Messpaar 60 dargestellt. Wird nur ein Messpaar 60 als Selektionspaar 80 aus einer bestimmten Anzahl an Messpaaren 60 ausgewählt, wie in Figur 3 gezeigt, so entspricht der Kehrwert der Zeitperiode Tₙ, in der die bestimmte Anzahl an Messpaaren 60 erfasst wird, der Verarbeitungsfrequenz f_{y} des Batteriemodells 30. Werden dagegen mehrere Selektionspaare aus der bestimmten Anzahl an Messpaaren gewählt, so muss zur Bestimmung der Verarbeitungsfrequenz f_{y} der Kehrwert der Zeitperiode Tₙ noch um die Anzahl der Selektionspaare multipliziert werden.

## Patentansprüche

1. Elektronischer Batteriesensor (10) umfassend wenigstens ein erstes Erfassungsmittel (40) zur Erfassung von Messwerten (50) und ein Batteriemodell (30) zur Ermittlung eines Innenwiderstandes (Rᵢ) einer Batterie (20),
- wobei jeder Messwert (50) zeitgleiche Informationen von wenigstens zwei korrespondierenden Messgrößen umfasst, nämlich Batteriestrom (I_{Batt}) und Batteriespannung (U_{Batt}), und
- wobei zwei aufeinanderfolgende Messwerte (50) je ein Messpaar (60) darstellen,
**dadurch gekennzeichnet, dass**
der Batteriesensor (10) zumindest ein Auswahlmittel (70) umfasst, welches dazu eingerichtet ist, aus einer bestimmten Anzahl von Messpaaren (60) wenigstens ein Messpaar (60) als Selektionspaar (80) auszuwählen und dem Batteriemodell (30) zur Ermittlung des Innenwiderstandes (Rᵢ) zur Verfügung zu stellen,
- wobei die Anzahl der Messpaare (60) größer als die Anzahl der Selektionspaare (80) ist.

2. Elektronischer Batteriesensor (10) nach Anspruch 1, **dadurch gekennzeichnet, dass** das Verhältnis von einer Arbeitsfrequenz (fₓ) des Erfassungsmittels (40) und/oder des Auswahlmittels (70) zu einer Verarbeitungsfrequenz (f_{y}) des Batteriemodells (30) dem Verhältnis von der Anzahl der Messpaare (60) zur Anzahl der Selektionspaare (80) entspricht.

3. Elektronischer Batteriesensor (10) nach Anspruch 1 oder 2, **dadurch gekennzeichnet, dass** das Auswahlmittel (70) dazu eingerichtet ist, dass jedes n-te Messpaar (60) der bestimmten Anzahl von Messpaaren (60) als Selektionspaar (80) ausgewählt wird.

4. Elektronischer Batteriesensor (10) nach Anspruch 1 oder 2, **dadurch gekennzeichnet, dass** das Auswahlmittel (70) dazu eingerichtet ist, in Abhängigkeit der Gradienten der Messpaare (60) wenigstens ein Messpaar (60) als Selektionspaar (80) auszuwählen, insbesondere das Messpaar (60) mit dem betragsmäßig größten Stromgradienten.

5. Elektronischer Batteriesensor (10) nach Anspruch 1 oder 2, **dadurch gekennzeichnet, dass** das Auswahlmittel (70) dazu eingerichtet ist, einen Mittelwert aller Messpaare (60) der bestimmten Anzahl der Messpaare (60) zu bilden und diesen Mittelwert als Selektionspaar (80) auszuwählen.

6. Elektronischer Batteriesensor (10) nach einem der Ansprüche 1 bis 5, **dadurch gekennzeichnet, dass** der Batteriesensor (10) einen Bandpassfilter (90) umfasst, wobei der Bandpassfilter (90) als Eingangsgrößen die Messwerte (50) aufweist und dazu eingerichtet ist, die Ausgangsgrößen dem Auswahlmittel (70) zur Verfügung zu stellen.

7. Elektronischer Batteriesensor (10) nach einem der vorhergehenden Ansprüche, **dadurch gekennzeichnet, dass** der Batteriesensor (10) ein Anpassmittel (100) umfasst, welches dazu eingerichtet ist, die Phasen der korrespondierenden Messgrößen aufeinander anzupassen.

8. Verfahren zur Bestimmung eines Innenwiderstandes (Rᵢ), insbesondere mittels eines elektronischen Batteriesensors nach Anspruch 1 bis 7, mit einem ersten Verfahrensschritt:
- Erfassen (110) von Messwerten (50), wobei jeder Messwert (50) zeitgleiche Informationen von wenigstens zwei korrespondierenden Messgrößen umfasst, nämlich Batteriestrom (I_{Batt}) und
Batteriespannung (U_{Batt}), und wobei zwei aufeinanderfolgende Messwerte (50) je ein Messpaar (60) darstellen,
**gekennzeichnet durch** einen zweiten, dritten und vierten Verfahrensschritt:
- Auswählen (120) wenigstens eines Messpaares (60) als Selektionspaar (80) aus einer bestimmten Anzahl von Messpaaren (60), wobei die Anzahl der Messpaare (60) größer als die Anzahl der Selektionspaare ist, und
- Zurverfügungstellen (130) des wenigstens einen Selektionspaares (80) zur Ermittlung des Innenwiderstandes (Rᵢ), und
- Berechnen (140) des Innenwiderstands (Rᵢ) anhand der Gradienten des wenigstens einen Selektionspaares (80).

9. Verfahren nach Anspruch 8, **dadurch gekennzeichnet, dass** das Verhältnis von einer Arbeitsfrequenz (fₓ) zum Erfassen (110) und/oder zum Auswählen (120) von Messpaaren (60) zu einer Verarbeitungsfrequenz (f_{y}) zum Berechnen (140) des Innenwiderstands (Rᵢ) dem Verhältnis von der Anzahl der Messpaare (60) zur Anzahl der Selektionspaare (80) entspricht.

10. Verfahren nach Anspruch 8 oder 9, **dadurch gekennzeichnet, dass** beim Auswählen (120) jedes n-te Messpaar (60) der bestimmten Anzahl von Messpaaren (60) als Selektionspaar (80) gewählt wird.

11. Verfahren nach Anspruch 8 oder 9, **dadurch gekennzeichnet, dass** beim Auswählen (120) die Gradienten der Messpaare (60) miteinander verglichen werden und in Abhängigkeit des Vergleichs wenigstens ein Messpaar (60) als Selektionspaar (80) ausgewählt wird, insbesondere das Messpaar (60) mit dem betragsmäßig größten Stromgradienten.

12. Verfahren nach Anspruch 8 oder 9, **dadurch gekennzeichnet, dass** beim Auswählen (120), ein Mittelwert aller Messpaare (60) der bestimmten Anzahl der Messpaare (60) gebildet und dieser Mittelwert als Selektionspaar (80) ausgewählt wird.

13. Verfahren nach einem der Ansprüche 8 bis 12, **gekennzeichnet durch** einen weiteren Verfahrensschritt, der zwischen dem Erfassen (110) und dem Auswählen (120) abläuft:
- Bandpassfiltern (150) der erfassten Messwerte (50).

14. Verfahren nach einem der Ansprüche 8 bis 13, **gekennzeichnet durch** einen weiteren Verfahrensschritt, der zwischen dem Erfassen (110) und dem Auswählen (120) abläuft:
- Phasenanpassen (160) der korrespondierenden Messgrößen.

## Claims

1. Electronic battery sensor (10) comprising at least one first capture means (40) for capturing measured values (50) and a battery model (30) for determining an internal resistance (Ri) of a battery (20),
- wherein each measured value (50) comprises contemporaneous information relating to at least two corresponding measurement variables, namely the battery current I_{Batt} and the battery voltage (U_{Batt}), and
- wherein two successive measured values (50) form one measurement pair (60),
**characterized in that**
the battery sensor (10) comprises at least one selection means (70) which is configured to select at least one measurement pair (60) as a selection pair (80) from a particular number of measurement pairs (60) and to make it available to the battery model (30) for the purpose of determining the internal resistance (Rᵢ),
- wherein the number of measurement pairs (60) is greater than the number of selection pairs (80) .

2. Electronic battery sensor (10) according to Claim 1, **characterized in that** the ratio of an operating frequency (fₓ) of the capture means (40) and/or of the selection means (70) to a processing frequency (f_{y}) of the battery model (30) corresponds to the ratio of the number of measurement pairs (60) to the number of selection pairs (80).

3. Electronic battery sensor (10) according to Claim 1 or 2, **characterized in that** the selection means (70) is configured in such a manner that every nth measurement pair (60) of the particular number of measurement pairs (60) is selected as a selection pair (80).

4. Electronic battery sensor (10) according to Claim 1 or 2, **characterized in that** the selection means (70) is configured to select at least one measurement pair (60) as a selection pair (80) on the basis of the gradients of the measurement pairs (60), in particular the measurement pair (60) with the greatest current gradient in terms of absolute value.

5. Electronic battery sensor (10) according to Claim 1 or 2, **characterized in that** the selection means (70) is configured to form a mean value of all measurement pairs (60) of the particular number of measurement pairs (60) and to select this mean value as a selection pair (80).

6. Electronic battery sensor (10) according to one of Claims 1 to 5, **characterized in that** the battery sensor (10) comprises a bandpass filter (90), wherein the bandpass filter (90) has the measured values (50) as input variables and is configured to make the output variables available to the selection means (70).

7. Electronic battery sensor (10) according to one of the preceding claims, **characterized in that** the battery sensor (10) comprises a matching means (100) which is configured to match the phases of the corresponding measurement variables to one another.

8. Method for determining an internal resistance (Rᵢ), in particular by means of an electronic battery sensor according to Claims 1 to 7, having a first method step of:
- capturing (110) measured values (50), wherein each measured value (50) comprises contemporaneous information relating to at least two corresponding measurement variables, namely the battery current I_{Batt} and the battery voltage (U_{Batt}), and wherein two successive measured values (50) form one measurement pair (60),
**characterized by** a second, a third and a fourth method step of:
- selecting (120) at least one measurement pair (60) as a selection pair (80) from a particular number of measurement pairs (60), wherein the number of measurement pairs (60) is greater than the number of selection pairs, and
- making (130) the at least one selection pair (80) available for the purpose of determining the internal resistance (Rᵢ), and
- calculating (140) the internal resistance (Ri) on the basis of the gradients of the at least one selection pair (80).

9. Method according to Claim 8, **characterized in that** the ratio of an operating frequency (fₓ) for capturing (110) and/or for selecting (120) measurement pairs (60) to a processing frequency (f_{y}) for calculating (140) the internal resistance (Rᵢ) corresponds to the ratio of the number of measurement pairs (60) to the number of selection pairs (80).

10. Method according to Claim 8 or 9, **characterized in that**, during selection (120), every nth measurement pair (60) of the particular number of measurement pairs (60) is selected as a selection pair (80).

11. Method according to Claim 8 or 9, **characterized in that**, during selection (120), the gradients of the measurement pairs (60) are compared with one another and at least one measurement pair (60) is selected as a selection pair (80) on the basis of the comparison, in particular the measurement pair (60) with the greatest current gradient in terms of absolute value.

12. Method according to Claim 8 or 9, **characterized in that**, during selection (120), a mean value of all measurement pairs (60) of the particular number of measurement pairs (60) is formed and this mean value is selected as a selection pair (80).

13. Method according to one of Claims 8 to 12, **characterized by** a further method step which takes place between capture (110) and selection (120):
- subjecting the captured measured values (50) to bandpass filtering (150).

14. Method according to one of Claims 8 to 13, **characterized by** a further method step which takes place between capture (110) and selection (120):
- matching the phases (160) of the corresponding measurement variables.

## Revendications

1. Capteur de batterie électronique (10) comprenant au moins un premier moyen de détection (40) servant à détecter des valeurs de mesure (50) et un modèle de batterie (30) servant à déterminer une résistance interne (Rᵢ) d'une batterie (20),
- dans lequel chaque valeur de mesure (50) comprend des informations simultanées d'au moins deux grandeurs de mesure correspondantes, à savoir le courant de batterie I_{Batt} et la tension de batterie (U_{Batt}), et
- dans lequel deux valeurs de mesure successives (50) représentent chacune une paire de mesures (60), **caractérisé en ce que**
le capteur de batterie (10) comprend au moins un moyen de sélection (70) qui est conçu pour sélectionner parmi un nombre déterminé de paires de mesures (60) au moins une paire de mesures (60) en tant que paire de sélection (80) et pour la fournir au modèle de batterie (30) afin de déterminer la résistance interne (Rᵢ),
- dans lequel le nombre de paires de mesures (60) est supérieur au nombre de paires de sélection (80).

2. Capteur de batterie électronique (10) selon la revendication 1, **caractérisé en ce que** le rapport entre une fréquence de fonctionnement (fₓ) du moyen de détection (40) et/ou du moyen de sélection (70) et une fréquence de traitement (f_{y}) du modèle de batterie (30) correspond au rapport entre le nombre de paires de mesures (60) et le nombre de paires de sélection (80).

3. Capteur de batterie électronique (10) selon la revendication 1 ou 2, **caractérisé en ce que** le moyen de sélection (70) est conçu pour sélectionner chaque n-ième paire de mesures (60) du nombre déterminé de paires de mesures (60) en tant que paire de sélection (80).

4. Capteur de batterie électronique (10) selon la revendication 1 ou 2, **caractérisé en ce que** le moyen de sélection (70) est conçu pour sélectionner au moins une paire de mesures (60) en tant que paire de sélection (80) en fonction des gradients des paires de mesures (60), en particulier la paire de mesures (60) présentant le gradient de courant ayant la valeur la plus élevée.

5. Capteur de batterie électronique (10) selon la revendication 1 ou 2, **caractérisé en ce que** le moyen de sélection (70) est conçu pour établir une valeur moyenne de toutes les paires de mesures (60) du nombre déterminé de paires de mesures (60) et pour sélectionner ladite valeur moyenne en tant que paire de sélection (80).

6. Capteur de batterie électronique (10) selon l'une des revendications 1 à 5, **caractérisé en ce que** le capteur de batterie (10) comprend un filtre passe-bande (90), dans lequel le filtre passe-bande (90) utilise les valeurs de mesure (50) en tant que grandeurs d'entrée et est conçu pour fournir les grandeurs de sortie au moyen de sélection (70).

7. Capteur de batterie électronique (10) selon l'une des revendications précédentes, **caractérisé en ce que** le capteur de batterie (10) comprend un moyen d'adaptation (100) qui est conçu pour adapter les unes aux autres les phases des grandeurs de mesure correspondantes.

8. Procédé servant à déterminer une résistance interne (Rᵢ), en particulier au moyen d'un capteur de batterie électronique selon les revendications 1 à 7, comprenant une première étape consistant à :
- acquérir (110) des valeurs de mesure (50), dans lequel chaque valeur mesurée (50) comprend des informations simultanées d'au moins deux grandeurs de mesure correspondantes, à savoir le courant de batterie (I_{Batt}) et la tension de batterie (U_{Batt}) et dans lequel deux valeurs de mesure successives (50) représentent chacune une paire de mesures (60),
**caractérisé par** des deuxième, troisième et quatrième étapes de procédé consistant à :
- sélectionner (120) au moins une paire de mesures (60) parmi un nombre déterminé de paires de mesures (60) en tant que paire de sélection (80), dans lequel le nombre de paires de mesure (60) est supérieur au nombre de paires de sélection, et
- fournir (130) ladite au moins une paire de sélection (80) pour déterminer la résistance interne (Rᵢ), et
- calculer (140) la résistance interne (Rᵢ) sur la base des gradients de ladite au moins une paire de sélection (80) .

9. Procédé selon la revendication 8, **caractérisé en ce que** le rapport entre une fréquence de fonctionnement (fₓ) pour la détection (110) et/ou la sélection (120) de paires de mesures (60) et une fréquence de traitement (f_{y}) pour le calcul (140) de la résistance interne (Ri) correspond au rapport entre le nombre de paires de mesures (60) et le nombre de paires de sélection (80).

10. Procédé selon la revendication 8 ou 9, **caractérisé en ce que**, lors de la sélection (120), chaque n-ième paire de mesures (60) du nombre déterminé de paires de mesures (60) est sélectionnée en tant que paire de sélection (80).

11. Procédé selon la revendication 8 ou 9, **caractérisé en ce que**, lors de la sélection (120), les gradients des paires de mesure (60) sont comparés les uns aux autres et, en fonction de la comparaison, au moins une paire de mesures (60) est sélectionnée en tant que paire de sélection (80), en particulier la paire de mesures (60) présentant le gradient de courant ayant la valeur la plus élevée.

12. Procédé selon la revendication 8 ou 9, **caractérisé en ce que**, lors de la sélection (120), une valeur moyenne de toutes les paires de mesures (60) du nombre déterminé de paires de mesures (60) est établie et ladite valeur moyenne est sélectionnée en tant que paire de sélection (80) .

13. Procédé selon l'une des revendications 8 à 12, **caractérisé par** une étape de procédé supplémentaire qui a lieu entre la détection (110) et la sélection (120), consistant à :
- soumettre à filtrage passe-bande (150) les valeurs de mesure (50) acquises.

14. Procédé selon l'une des revendications 8 à 13, **caractérisé par** une étape de procédé supplémentaire qui a lieu entre l'acquisition (110) et la sélection (120), consistant à :
- adapter en phase (160) les grandeurs de mesure correspondantes.
